(19) Europäisches Patentamt
European Patent Office
Office européen des brevets

(11) Publication number: **0 360 274 B1**

(12) # EUROPEAN PATENT SPECIFICATION

(45) Date of publication of patent specification: **15.06.94**

(51) Int. Cl.⁵: **C08G 77/24**, G03F 7/26, C08G 77/26, C08G 77/06

(21) Application number: **89117512.7**

(22) Date of filing: **22.09.89**

The file contains technical information submitted after the application was filed and not included in this specification

(54) **Silicon-containing polymer and photosensitive material containing the same.**

(30) Priority: **22.09.88 JP 236299/88**

(43) Date of publication of application:
**28.03.90 Bulletin 90/13**

(45) Publication of the grant of the patent:
**15.06.94 Bulletin 94/24**

(84) Designated Contracting States:
**BE DE FR GB NL**

(56) References cited:
**EP-A- 0 164 598**
**EP-A- 0 246 169**
**US-A- 4 069 178**

**PATENT ABSTRACTS OF JAPAN vol. 8, no. 254 (P-315)(1691), 21 November 1984; & JP - A - 59125730 (FUJITSU K.K.) 20.07.1984**

**PATENT ABSTRACTS OF JAPAN vol. 10, no. 132 (P-456)(2189), 16 May 1986; & JP - A - 60254034 (FUJITSU K.K.) 14.12.1985**

(73) Proprietor: **Tosoh Corporation**
**4560, Kaisei-cho**
**Shinnanyo-shi, Yamaguchi-ken(JP)**

Proprietor: **NIPPON TELEGRAPH AND TELEPHONE CORPORATION**
**1-6 Uchisaiwai-cho 1-chome**
**Chiyoda-ku**
**Tokyo(JP)**

(72) Inventor: **Tanaka, Akinobu**
**No. 1182-1, Hase**
**Atsugi-shi Kanagawa-ken(JP)**
Inventor: **Hasegawa, Masazumi**
**No. 10-3-118, Madokoro 4-chome**
**Shin Nanyo-shi Yamaguchi-ken(JP)**

(74) Representative: **VOSSIUS & PARTNER**
**Postfach 86 07 67**
**D-81634 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

The present invention relates to a novel silicon-containing polymer and a novel photosensitive material containing siloxane linkages, which is a material for a resist having groups which are photosensitive to electron rays, X-rays, UV light and deep UV light which are applied in the production of semiconductor integrated circuits. The novel material is also usable as a layer-insulation film or a protective film.

Silicon-containing polymers are used in a variety of fields for the reasons that they exhibit excellent heat resistance and cold resistance and that the electric characteristics thereof are stable over a wide range of temperature. Moreover, silicon-based polymers provided with photosensitive groups have been developed in recent times and the uses are spreading out as electronic materials, too; see e.g. JP-A-59-125 730.

In the electronic field, particularly in the production of semiconductors (integral circuits), the fine processing of substrates has become more complicated and higher precision has been requested for high integration progresses. Accompanying with this, the technique for performing the fine processing in a scale of submicron on a substrate with difference in level has become problematic and various methods have been contrived. As one of them, the two-layer resist technique using a silicon-based resist as the top layer was proposed, which is particularly spotlighted in recent times.
This technique will be explained in more detail.

A resin or resist which is resistant to gaseous halogen is spin-coated onto a substrate as a bottom layer, which is subject to soft- or hard-baking. Then, a silicon-based resist is spin-coated onto the bottom layer as a top layer. Using an exposure device, the top layer resist is exposed to light and only the top layer is developed. Then, using the pattern area of the top layer resist as a mask, the bottom layer resist is etched with $O_2$ gas plasma. Finally, using the bottom layer resist as a mask, the substrate is etched with a gaseous halogen.

The functions to be requested for the top layer resist are as follows:

(1) To be excellent in resistance to $O_2$ plasma.
(2) To be excellent in flatness.
(3) To have high glass transition temperature.
(4) To have high resolution
(5) To have high sensitivity.

Silicon-containing polymers are excellent in resistance to $O_2$ plasma and some resist materials containing them are known. For example, there has been proposed a method to attach silyl groups directly or indirectly to the benzene rings of a Novolak resin or polystyrene, a method using the polysilane linkage, and, in particular, recently, a method using a ladder polymer (silsesquioxane linkage).

In the case of the compounds having silyl groups attached directly or indirectly to benzene rings, however, a problem that the resistance to $O_2$ plasma is insufficient exists because the content of Si is low and the Si is contained in a side chain. Moreover, in the case of compounds of the polysilane type, poor coating property and stability are generally encountered though the content of Si may be increased depending on the kind of compounds. Furthermore, in the case of silsesquioxane type polymers, there is a problem that the sensitivity is not enough though the resistance to $O_2$ plasma is excellent.

As described above, a resist material being excellent in resistance to $O_2$ plasma and flatness and having all of high Tg, high resolution and high sensitivity has not yet been developed in the prior art. It is the object of the present invention to overcome the problems mentioned above and to provide a novel silicon-containing polymer and a photosensitive material containing the same, which is excellent in resistance to $O_2$ plasma and flatness and which has high Tg, high resolution and high sensitivity.

This object could be achieved on the basis of the surprising finding that, by using a polymer having a single cyclic siloxane compound as a repeating unit or a copolymer having various cyclic siloxane compounds as repeating units, a resist material being highly sensitive, highly flat and excellent in resistance to $O_2$ plasma and yet having high Tg can be obtained.

The subject matter of the invention therefore is a silicon-containing polymer comprising repeating units of a silicon-containing cyclic compound represented by the general formula (I),

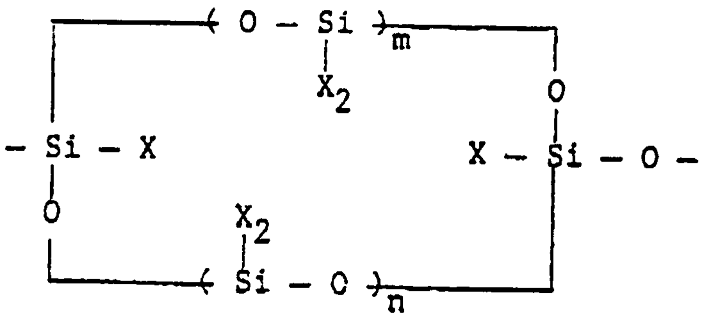

(I)

wherein m and n are positive integers including 0, however m + n > 0, and X is an alkyl group, alkoxy group, phenyl group, naphthyl group, substituted phenyl group or substituted naphthyl group or a mixture thereof, the substituent of said substituted phenyl group or substituted naphthyl group being a halogen atom, halogenated alkyl group, amino group, aminoalkyl group or nitro group or a mixture thereof.

Preferably, m + n is any of 1 to 4.

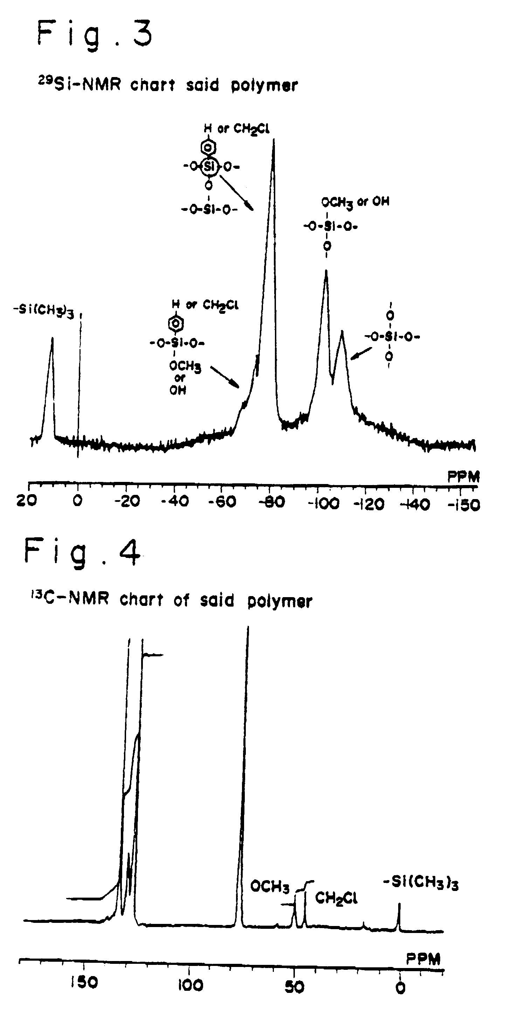

Fig. 1 shows a $^{29}$Si-NMR chart of hexaphenylcyclotrisiloxane being a starting raw material in Production Example 2 of the invention, Fig. 2 shows an FD-MS chart of the product at 10 minutes after the initiation of the polymerization reaction in the same Production Example 2, and Fig. 3 and Fig. 4 show a $^{29}$Si-NMR chart and a $^{13}$C-NMR chart of the product, respectively, after the completion of the polymerization reaction in the same Production example 2.

The alkyl group in the definition of X in the general formula (I) is not particularly restricted. Preferred are $C_{1-20}$, more preferred $C_{1-12}$alkyl groups. Specific examples for straight chain alkylgroups are methyl, ethyl, propyl, butyl, pentyl, hexyl, octyl, decyl, dodecyl, vinyl, propenyl, butenyl, pentenyl, hexenyl, octenyl, decenyl, and dodecenyl groups. Specific examples for branched alkyl groups are sec-propyl, sec-butyl, t-butyl, 2-methylpropyl, 2-methylbutyl, neopentyl, 1-methylpentyl, 2-methylpentyl, 4-methylpentyl, and 2-ethylhexyl groups. Part of the hydrogens in said alkyl groups may be substituted by a halogen atom such as F, Cl, Br or I and/or by a phenyl, naphthyl, substituted phenyl or substituted naphthyl group. As a substituent in said substituted phenyl or substituted naphthyl, for example, a chlorine, fluorine or bromine atom, a nitro group, alkyl group or amino group can be mentioned. X may also be a $C_{3-8}$ cycloalkyl group, for example a cyclopropyl, cyclopropenyl, cyclobutyl, cyclobutenyl, cyclopentyl, cyclopentenyl, cyclohexyl, cyclohexenyl, cyclooctyl or cyclooctenyl group. The alkyl part of other groups can also contain 1 to 20, preferably 1 to 12 carbon atoms. Examples for X as an alkoxy group are a methoxy, ethoxy, propoxy, butoxy, pentoxy or phenoxy group.

Since the resist material of the invention has a siloxane structure containing Si atoms in the main chain of the polymer and the content of Si is also high, it is very high in resistance to $O_2$ plasma and further, because of the cyclic ring structure, it has a high Tg. Of course, when a higher Tg is desired, this can easily be obtained by introducing a phenyl group or naphthyl group to the side chain attached to the Si atom.

In order to make the material photosensitive a residue containing a photosensitive group, for example, a halogenated alkyl group or aminoalkyl group, may be attached directly to the Si atom or as a side chain thereof in the polymer of the invention, a photosensitive agent may be added to the polymer of the invention.

For producing the siloxane polymer of the invention represented by the general formula (I), there are two ways starting from a monomer or from a cyclic ring. For example, when starting from a monomer, the following reactions are conducted:

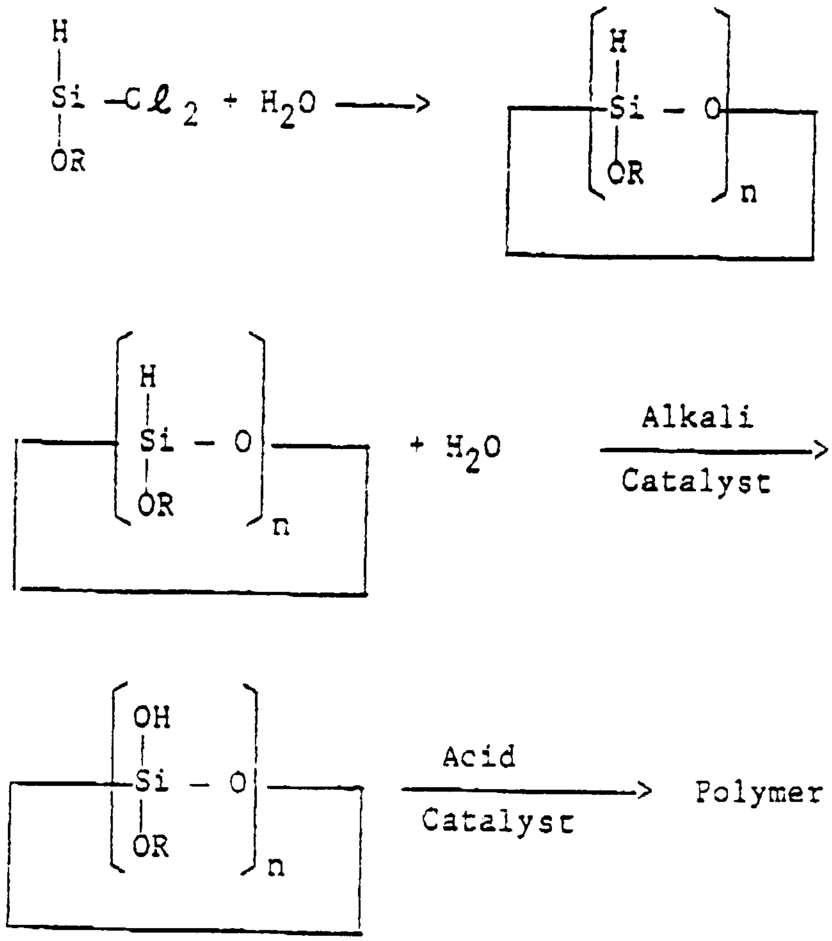


(R: Arbitrary substituent, n: Positive integer)

Moreover, when starting from a cyclic ring, a rearrangement using a Lewis acid or a dissociation reaction of the Si-C bond may be performed.
For example, when carrying out the reaction sequence

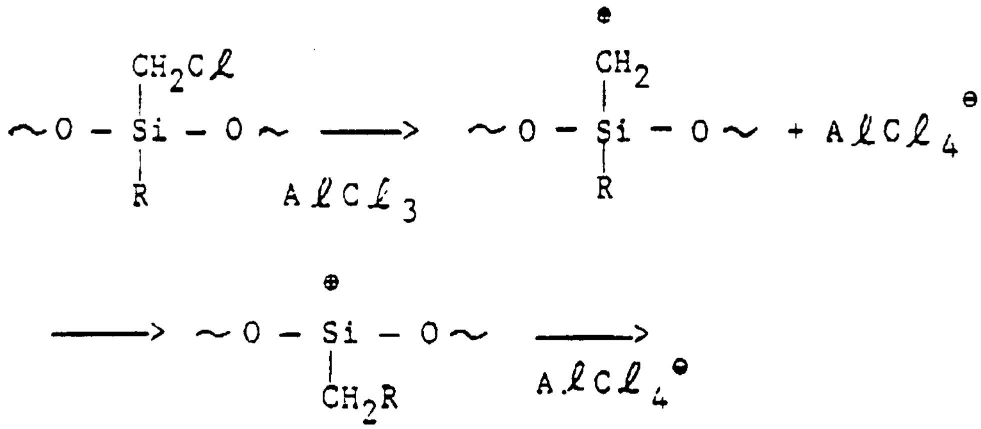


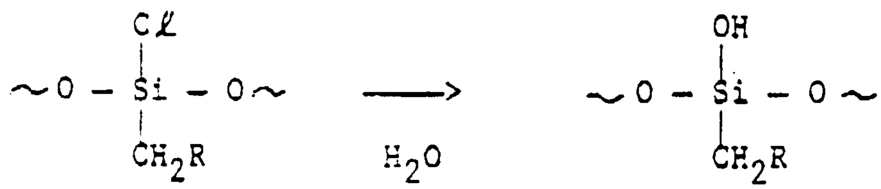


the reaction 2SiOH→Si-O-Si is used to perform polymerization (R: arbitrary substituent).

Furthermore, when using a cylic ring containing a phenyl group as a starting raw material, the following reaction is carried out.

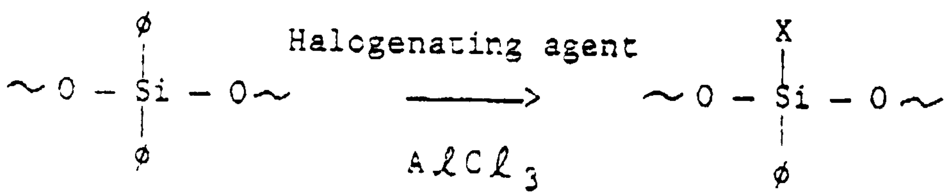


φ : Phenyl group

Thereafter $H_2O$ or an alcohol is allowed to react with the product to convert the SiX to SiOH or SiOR′ (R: arbitrary substituent). As a halogenating agent to be used here, acids such as H-Hal (Hal: halogen atom), $Hal_2$, an alkyl halide, thionyl halide or sulfonyl halide can be mentioned.

By adding a photosensitive agent or introducing a photosensitive group into the polymer of the invention produced according to the aforementioned reactions, the polymer becomes usable as a photosensitive material. For introducing the photosensitive group, there is a method of preparing a cyclic ring using a compound which can become the photosensitive group, for example, an Si compound having a double bond such as $H_2C=CH-CH_2$-Si for the production of the side chain attached to the Si atom. Alternatively, the photosensitive group may be introduced into the side chain attached to the Si atom after the production of the polymer or a photosensitive agent may be added. Further, if necessary, coupling of SiOH or SiOR'' (R'': alkyl group or phenyl group) contained in the polymer of the invention may be conducted with a silane coupling agent. Still more, if need be, a commonly used crosslinking agent or sensitizer may be added.

In the following, the invention will be illustrated in more detail based on examples, but the invention is not confined thereto.

Production Example 1

To 100 g of ether cooled with ice were added 10 g of $\phi$ $SiHCl_2$. Then, a small amount of hydrochloric acid (35 % aqueous solution) and 50 g of chloromethyl methyl ether were added under stirring and the mixture was stirred for about 30 minutes under cooling with ice. After the completion of the reaction, the reaction product was added dropwise to a large amount of methanol to obtain a precipitate. Two peaks were recognized on analyzing the precipitate with silicon NMR. When fractionating with GPC to analyze, the precipitate was confirmed to be a mixture of two kinds of compounds, i.e. trisilylcyclosiloxane and tetrasilylcyclosiloxane. Then, 5 g of the precipitate were dissolved in 100 g of a THF (tetrahydrofuran) solution containing approximately 0.5 % by weight of water and triethylamine was added in a small amount under violent stirring. Thereafter, the reaction liquor was added dropwise benzene to precipitate the cyclosiloxane compound. When taking the H-NMR of the precipitate, a peak originating from SiOH was identified. Successively, for the chloromethylation, 5 g of the precipitate previously obtained were added to a solution of 100 g of methylal and 8 g of thionyl chloride, which was adjusted to -20 °C while stirring. Then, Lewis acid (e.g. $FeCl_3$) was added in a small amount to allow the polymerization reaction and the chloromethylating reaction to progress concurrently. After reacting for about 20 hours, this reaction product was added dropwise at 0 °C to a large amount of a solution comprising methanol and water (1:1) to precipitate the polymer. When determining the molecular weight after drying, it was found to be MW = 10000 (in terms of polystyrene) and the content of Cl was 4.1 % by weight.

Example 1

To 45 g of DIBK (dibutyl ketone) were added 5 g of the polymer obtained in Production Example 1. The mixture was stirred and completely dissolved. Then, the solution was filtered through a 0.2 µm filter to make up a resist solution. Following this, OFPR-800 (photoresist made by Tokyo Oka Co.) was coated onto a silicone substrate with 7.62 cm (3 in) in a thickness of 1 µm. The coating was baked for about 30 minutes at 200 °C in an oven. After baking, said resist solution was coated while adjusting the number of revolutions of the spin coater to obtain a thickness of 0.2 µm. After baking again for 20 minutes at 80 °C, a picture was drawn using an electron rays exposure device. Next, the development was performed with a solution of 1-methoxy-2-propanol/di-n-butyl ether (ratio = 5/2). The sensitivity at this time was 12 $\mu C/cm^2$. The rate of residual resist film was 50%. Successively, etching with $O_2$ gas was performed with the use of a dry etching device (RIE).

Etching conditions:

| | |
|---|---|
| Gas flow rate | 40 SCCM* |
| RF power | 125 W |
| $O_2$ pressure | 5.3 Pa (40 m Torr) |

*standard cubic centimeter per minute

Etching speed

| | |
|---|---|
| Resist of the invention | 3 nm/min (30 Å/min) |
| OFPR-800 | 200 nm/min (2000 Å/min) |

As above, the resist of the invention was confirmed to be excellent in the resistance to $O_2$ plasma. When measuring the resolution with an electron microscope, a gap pattern with a line width of 3 µm and a space width of 0.2 µm was resoluted distinctly.

Example 2

The resist material prepared in Production Example 1 was spin-coated onto a silicon wafer while adjusting the number of revolutions to obtain a thickness of 0.35 µm. Thereafter, this was baked for 20 minutes at

80 ° C in an oven and drawing and development were made by the same technique as in Example 1. Thereafter, when baking for 30 minutes at 80 ° C or 160 ° C, the line width of the pattern was not changed at either temperature. That is to say, it could be confirmed that a flow of the resist did not take place even during baking at high temperature.

Production Example 2

To 80 g of methylal were added 6 g of commercial hexaphenylcyclotrisiloxane. (In the silicon NMR, two peaks were detected at 33-34 ppm and 43 ppm (see Fig. 1). By FD-MS measurement (electrolytically eliminated ion-mass spectrum), this was confirmed to be a mixture of a compound with a mass of 594 originating from hexaphenylcyclotrisiloxane and a compound with a mass of 792 originating from octaphenylcyclotetrasiloxane). After addition of 10 g of thionyl chloride, the mixture was stirred and the temperature of the solution was adjusted so as to become -20 ° C. Next, a small amount of $FeCl_3$ catalyst was added to concurrently progress the polymerization and the chloromethylating reaction for 20 hours. After the completion of the reaction, the reaction product was added dropwise to a solution of methanol : water = 1 : 1 to precipitate the polymer. When measuring the molecular weight with GPC after drying, this was found to be MW = 39000 and the content of Cl was 6.8 % by weight.

In this polymerization procedure, sampling was made at 10 minutes after the addition of catalyst to conduct FD-MS measurement. Results are shown in Fig. 2. Further, results of silicon NMR, $^{13}C$-NMR and elemental analysis of a sample after the completion of reaction are shown in Fig. 3, Fig. 4 and Table 1, respectively.

From the results of the analysis above, the structure of the present polymer is assumed as follows:

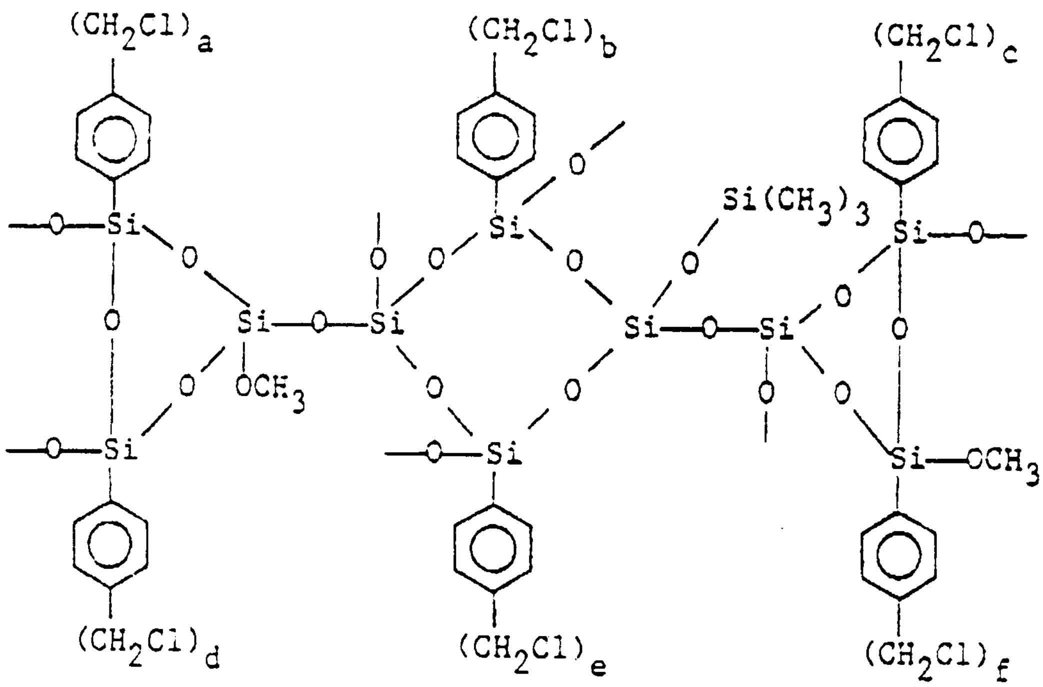

$$a + b + c + d + e + f = 2 \text{ or } 3$$

Table 1

| Results of elemental analysis | | | | |
|---|---|---|---|---|
| | C | H | Si | Cℓ |
| Polymer | 42.7 % | 3.6 % | 24.7 % | 6.8 % |

Example 3

Except that 3.5 g of the polymer obtained in Production Example 2 were dissolved in 48 g of DIBK, entirely the same procedure was used as in Examples 1 and 2.

- Sensitivity
  very high sensitive was obtained as proved by 50% rate of residual film = 2.8 μC/cm$^2$.
- Etching speed
  Resist of the invention 2 nm/min (20 Å/min) OFPR-800 200 nm/min (2000 Å/min)
- Resolution
  Distinct gap pattern of L/S = 3 μm/0.2 μm was obtained
- Test for heat resistance
  Even when post-baking was performed for 30 minutes at 80 °C or 160 °C, the line width of the pattern was not changed.

Example 4

3.5 g of the resin obtained in Production Example 2 and 1.2 g of 4,4'-diazidobenzophenone were dissolved in 45 g of DIBK. The solution was filtered through a 0.2 μm filter to obtain a resist solution.

OFPR-800 was coated onto a wafer with 7.62 cm (3 in) to a film thickness of 1.2 μm, which was baked for 30 minutes at 200 °C. Next, the resist of the invention was coated in a thickness of 0.2 μm. Closely contacting exposure was conducted using PLA-521F (deep UV light). Thereafter, etching was performed under the same conditions as in Example 1.

- Sensitivity
  Very high sensitivity was confirmed also to the deep UV light as proved by a 70 % rate of residual film = 2.2 L.I.
- Etching speed
  Resist of the invention 2.5 nm/min (25 Å/min) OFPR-800 200 nm/min (2000 Å/min)

As above, the resist of the invention was confirmed to have sufficient resistance to $O_2$ even when adding a photocrosslinking agent.

Resolution

Distinct pattern of L/S = 0.5 μm/0.5 μm was obtained. As illustrated above, the photosensitive material comprising the novel silicon-containing polymer having silicon-containing cyclic groups as repeating units in accordance with the invention is highly sensitive to electron rays, X-rays, deep UV light and UV light. Moreover, it has high etching resistance to $O_2$ because the main chain comprises siloxane linkages and the content of Si is high, it is also excellent in heat resistance because of the cyclic rings, and further it has high resolution. It is therefore suitable for the production of semiconductor integrated circuit elements such as super LSI (large scale integrated circuit).

## Claims

**1.** A silicon-containing polymer comprising repeating units of a silicon-containing cyclic compound, represented by the general formula (I)

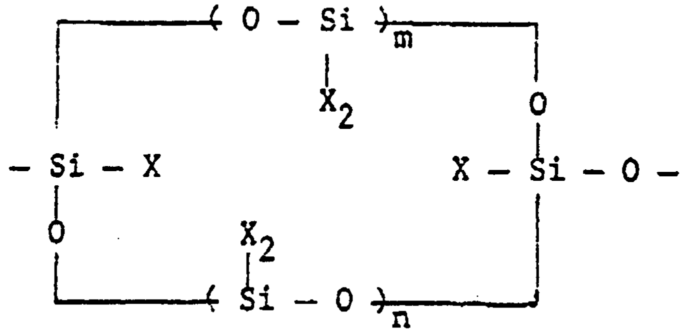

(I)

wherein m and n are positive integers including 0, however, m + n > 0, and X is an alkyl group, alkoxy group, phenyl group, naphthyl group, substituted phenyl group or substituted naphthyl group or a mixture thereof, the substituent of said substituted phenyl group or substituted naphthyl group being a halogen atom, halogenated alkyl group, amino group, aminoalkyl group or nitro group or a mixture thereof.

2. The silicon-containing polymer according to claim 1, wherein m + n is any of 1 to 4.

3. The silicon-containing polymer according to claim 1, wherein the polymer has a single cyclic siloxane compound as a repeating unit or the polymer is a copolymer having various cyclic siloxane compounds as repeating units and m + n is 1 to 4.

4. A photosensitive material comprising the silicon-containing polymer according to any one of claims 1 to 3.

5. The photosensitive material according to claim 4, wherein the photosensitive group is attached directly to the Si atom or is contained in the side chain which is attached to the Si atom.

6. The photosensitive material according to Claim 4, wherein the photosensitive agent is added to the polymer.

7. The use of a silicon-containing cyclic compound, represented by the general formula (I) for the production of a resist for integral circuits.

**Patentansprüche**

1. Siliziumhaltiges Polymer, umfassend wiederkehrende Einheiten einer siliziumhaltigen cyclischen Verbindung der allgemeinen Formel (I)

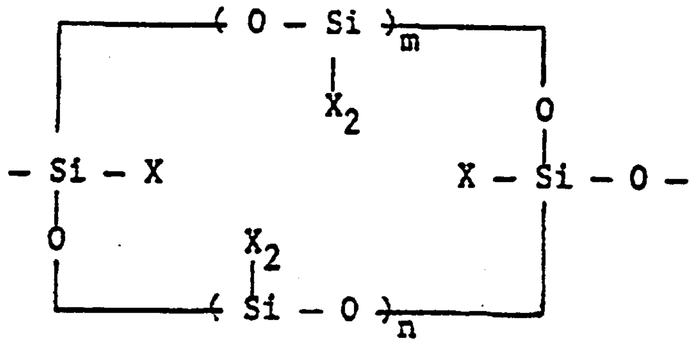

(I)

in der m und n positive ganze Zahlen einschließlich 0 sind, jedoch m + n > 0 ist, und X ein Alkylrest, Alkoxyrest, eine Phenylgruppe, Naphthylgruppe, substituierte Phenylgruppe oder substituierte Naphthylgruppe oder ein Gemisch davon ist, wobei der Substituent der substituierten Phenylgruppe oder

substituierten Naphthylgruppe ein Halogenatom, halogenierter Alkylrest, eine Aminogruppe, Aminoalkylrest oder Nitrogruppe oder ein Gemisch davon ist.

2. Siliziumhaltiges Polymer nach Anspruch 1, wobei m + n eine Zahl von 1 bis 4 ist.

3. Siliziumnaltiges Polymer nach Anspruch 1, in dem das Polymer eine einzelne cyclische Siloxanverbindung als wiederkehrende Einheit aufweist oder das Polymer ein Copolymer mit verschiedenen cyclischen Siloxanverbindungen als wiederkehrende Einheiten ist, und m + n eine Zahl von 1 bis 4 ist.

4. Photosensitives Material, umfassend das siliziumhaltige Polymer nach einem der Ansprüche 1 bis 3.

5. Photosensitives Material nach Anspruch 4, in dem die photosensitive Gruppe direkt an das Siliziumatom gebunden ist oder in der Seitenkette enthalten ist, die an das Siliziumatom gebunden ist.

6. Photosensitives Material nach Anspruch 4, in dem das photosensitive Agens zum Polymer gegeben wird.

7. Verwendung einer siliziumhaltigen cyclischen Verbindung der allgemeinen Formel (I) zur Herstellung eines Photolacks für Integralschaltungen.

## Revendications

1. Polymère contenant du silicium comprenant des motifs récurrents constitués d'un composé cyclique contenant du silicium, représenté par la formule générale (I)

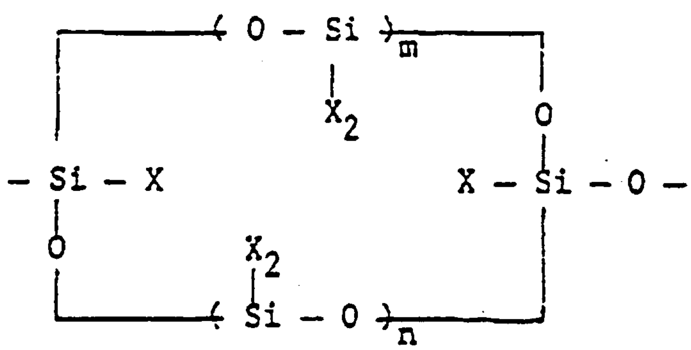

(I)

dans laquelle m et n sont des nombres entiers positifs pouvant être 0, cependant m + n > 0, et X est un groupement alkyle, un groupement alcoxy, un groupement phényle, un groupement naphtyle, un groupement phényle substitué ou un groupement naphtyle substitué ou un mélange de ceux-ci, les substituants dudit groupement phényle substitué ou dudit groupement naphtyle substitué étant un atome d'halogène, un groupement alkyle halogéné, un groupement amine, un groupement aminoalkyle ou un groupement nitro ou un mélange de ceux-ci.

2. Polymère contenant du silicium selon la revendication 1, dans lequel m + n vaut une valeur quelconque comprise entre 1 et 4.

3. Polymère contenant du silicium selon la revendication 1, dans lequel le polymère contient un unique composé siloxane cyclique, en tant que motif récurrent, ou le polymère est un copolymère contenant différents composés siloxane cycliques en tant que motifs récurrents et m + n vaut de 1 à 4.

4. Matériau photosensible comprenant le polymère contenant du silicium selon l'une quelconque des revendications 1 à 3.

5. Matériau photosensible selon la revendication 4, dans lequel le groupement photosensible est directement lié à l'atome de Si ou est contenu dans la chaîne latérale qui est liée à l'atome de Si.

**6.** Matériau photosensible selon la revendication 4, dans lequel l'agent photosensible est ajouté au polymère.

**7.** Utilisation d'un composé cyclique contenant du silicium représenté par la formule générale (I) pour la production d'un vernis sensible pour des circuits intégrés.

# Fig. 1

$^{29}$Si-NMR chart of hexaphenylcyclotrisiloxane

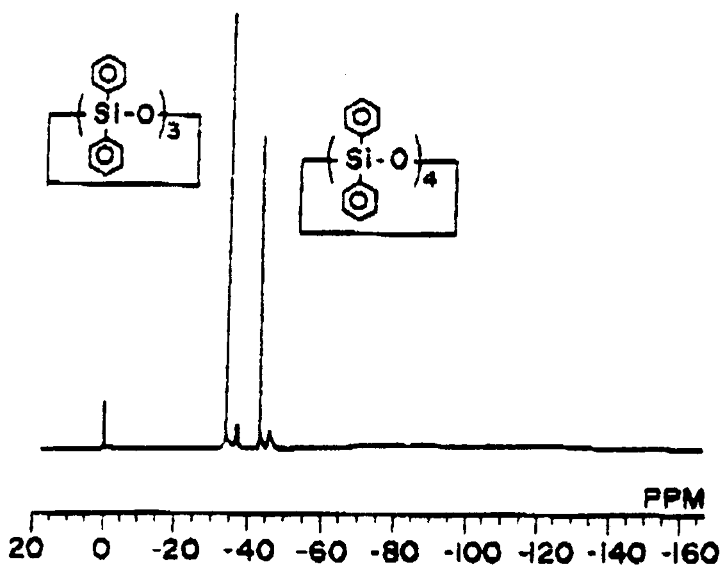


# Fig. 2

FD-MS chart

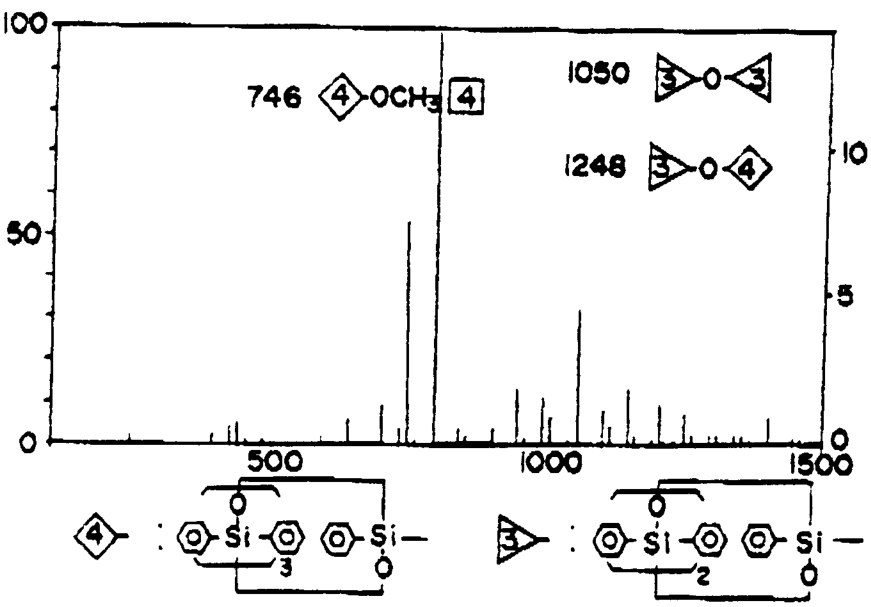

Fig. 3

$^{29}Si$-NMR chart said polymer

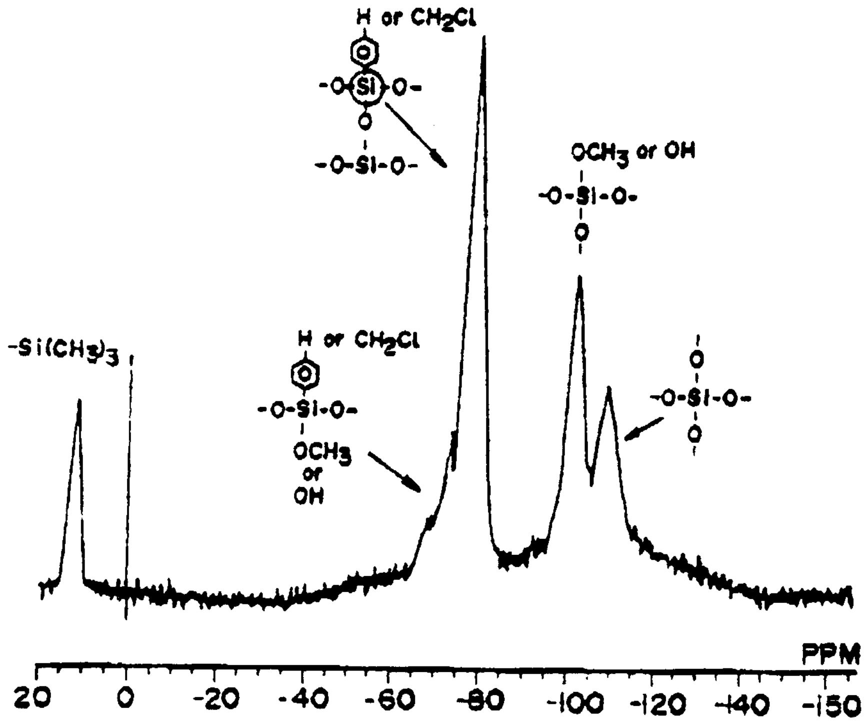


Fig. 4

$^{13}C$-NMR chart of said polymer